# EUROPEAN PATENT SPECIFICATION

(11) **EP 3 937 175 B1**
(45) Date of publication and mention of the grant of the patent: **07.02.2024**
(21) Application number: 19946694.7
(22) Date of filing: 24.12.2019
(51) Int. Cl.: G11C 5/02, G11C 5/06, G11C 11/409, G11C 11/407, G11C 7/18, G11C 8/14, G11C 11/408, G11C 11/4097

(54) **DRAM MEMORY**
DRAM-SPEICHER
MÉMOIRE DRAM

(30) Priority: 24.09.2019 CN 201910904496
(43) Date of publication of application: 12.01.2022
(73) Proprietor: Changxin Memory Technologies, Inc., Anhui 230000 (CN)
(72) Inventor: JI, Kangling, Hefei, Anhui 230000 (CN); SHANG, Weibing, Hefei, Anhui 230000 (CN); LI, Hongwen, Hefei, Anhui 230000 (CN)
(74) Representative: V.O.
(86) International application number: PCT/CN2019/127862
(87) International publication number: WO 2021/056887

(56) References cited:
- US-A- 5 914 907
- US-A- 5 943 285
- US-A- 6 069 812
- US-A- 6 081 450
- US-A- 6 121 677
- US-A1- 2010 142 246
- US-B1- 6 329 678
- US-B1- 6 448 602
- US-B1- 6 448 602

## Description

### Cross References to Related Applications

This disclosure claims priority to Chinese Patent Application No. 201910904496.8 filed on September 24, 2019, entitled "A DRAM MEMORY".

### Technical Field

The present disclosure relates to the field of memory device, in particular to a DRAM memory device.

### Background

Dynamic Random Access Memory (DRAM) is a commonly used semiconductor memory device in computers, and its memory array area is composed of many repeated memory cells. Each memory cell usually includes a capacitor and a transistor. The gate of the transistor is connected to the word line, the drain is connected to the bit line, and the source is connected to the capacitor. The voltage signal on the word line can control the opening or closing of the transistor, and then read the data information stored in the capacitor through the bit line, or write the data information into the capacitor for memory through the bit line.

The existing DRAM memory organization structure includes a plurality of banks, each bank is divided into two memory blocks of the same size at the top and at the bottom. However, the existing organizational structure of DRAM memory has problems such as high power consumption and room for improvements in data transmission rate and data transmission accuracy.

D1 (US6448602B1) discloses a semiconductor memory device, the semiconductor memory device includes: a semiconductor substrate; a plurality of memory blocks, each memory block having an outer peripheral boundary delineating an entire area of the memory block with each memory block including a plurality of word lines, a plurality of bit lines crossing the plurality of word lines, and a plurality of memory cells corresponding to crossing points of the plurality of word lines and the plurality of bit lines positioned within the entire area of the memory block, a portion of the outer peripheral boundary of each memory block corresponding to a portion of the outer peripheral boundary of each adjacent memory block, the plurality of memory blocks being arranged on the semiconductor substrate to completely surround a center of the semiconductor substrate; and a peripheral circuit for the plurality of memory blocks arranged on the semiconductor substrate at a center of the memory blocks, completely surrounded by the plurality of memory blocks.

D2 (US2010142246A1) discloses a semiconductor memory device, the semiconductor memory device includes: a plurality of memory cell mats; a plurality of sub-word driver regions disposed adjacently to the memory cell mats and arranged along a first direction; a plurality of sense amplifier regions disposed adjacently to the memory cell mats and arranged along a second direction substantially perpendicular to the first direction; a plurality of intersection regions each disposed between corresponding adjacent ones of the sub-word driver regions and between corresponding adjacent ones of the sense amplifier regions, the plurality of intersection regions including a plurality of first regions and a plurality of second regions different from the first regions; a plurality of sub-amplifiers disposed correspondingly in the first regions of the intersection regions; and a plurality of sub-amplifier control circuits each disposed in one of the second regions of the intersection regions, and each of the sub-amplifier control circuits supplying a control signal to corresponding one or ones of the sub-amplifiers based on a corresponding one of sub-amplifier timing signals supplied thereto from the first direction so as to activate the corresponding one or ones of the sub-amplifiers.

### Brief Summary

The technical problem to be solved by the present disclosure is how to reduce the power consumption of the DRAM memory and how to improve the data transmission rate and data transmission accuracy.

The present invention provides a DRAM memory, as defined in the appended claims.

Compared with the existing techniques, the technical solution of the present disclosure has the following advantages:

The DRAM memory of the present disclosure includes: a substrate; a plurality of memory banks arranged in rows and columns on the substrate, each memory bank is divided into three memory blocks in the column direction, and each memory block includes a plurality of memory cells arranged in rows and columns. First, as the capacity of each bank is constant, dividing each memory bank into three memory blocks in the column direction, and the length of each memory block in the column direction will be shorter (compared to the scheme of dividing each memory bank into two memory blocks in the column direction), so that the length of the control circuit itself will be shorter, and the distance from the control circuit to a corresponding memory cell in the memory array of each memory block will be shorter too, therefore it does not require a large drive, reducing power consumption. In addition, it shortens the length of the data transmission circuit itself, and the distance from the data transmission circuit to the corresponding memory cell in the memory array of each memory block will be shortened too, thereby reducing the parasitic resistance and parasitic capacitance generated by the data transmission circuit, and improving the data transmission rate and data transmission accuracy, as well as reducing power consumption. In addition, shortening the length of the memory blocks in the memory banks can optimize the memory bank layout in the DRAM memory, and optimize the aspect ratio of the DRAM memory, which is beneficial to later packaging.

Further, the first memory block is connected to a first column decoding circuit, the second memory block is connected to a second column decoding circuit, and the third memory block is connected to a third column decoding circuit in each memory bank. The first memory block, the second memory block and the third memory block in each memory bank also connect to the first row decoding circuit and the second row decoding circuit. The first column decoding circuit, the second column decoding circuit, and the third column decoding circuit are used to perform column addressing on corresponding memory cells in the first memory block, the second memory block and the third memory block respectively. The first row decoding circuit and the second row decoding circuit are used to perform row addressing on corresponding memory cells in the first memory block, the second memory block, and the third memory block. Therefore, it is possible to simultaneously access the corresponding memory cells in the three memory blocks of one memory bank (including reading, writing or refreshing), thereby improving the operation efficiency of the DRAM memory.

In an embodiment, the first row decoding circuit is connected to all the memory cells in the first memory block and some memory cells in the second memory block, and is configured to perform row addressing on all memory cells in the first memory block and some memory cells in the second memory block. The second row decoding circuit is connected to all memory cells in the third memory block and some memory cells in the second memory block, and is configured to perform row addressing on all memory cells in the third memory block and some memory cells in the second memory block. Therefore, the row decoding of the memory cells in the three memory blocks in one memory bank can share their control, saving the area of the chip.

### Brief Description of the Drawings

FIG. 1 is a schematic structural diagram of a DRAM memory according to an example of the prior art which is not in accordance with the claimed invention and is present for illustration purposes only; and
FIG. 2 is a schematic structural diagram of a DRAM memory according to an embodiment of the present invention.

### Detailed Description

As mentioned in the background, the existing organizational structure of a DRAM memory has the issues of high power consumption and data transmission rate and data transmission accuracy still need to be improved during operation.

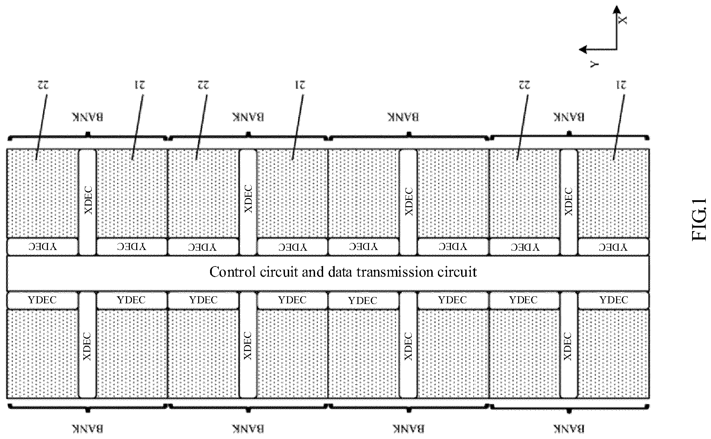

Referring to FIG. 1, FIG. 1 is a schematic structural diagram of a DRAM memory according to an example of the prior art which is not in accordance with the claimed invention and is present for illustration purposes only.

The DRAM memory includes a plurality of banks arranged in rows and columns a plurality of (the row direction is along the X axis in FIG. 1, and the column direction is along the Y axis in FIG. 1). In Fig. 1, 8 memory banks are taken as an example for illustration. Each memory bank is divided into two upper and lower memory blocks of the same size, including a first memory block 21 and a second memory block 22. The first memory block 21 and the second memory block 22 include a memory array or a plurality of memory cells arranged in rows and columns. The first memory block 21 and the second memory block 22 are respectively connected to the corresponding row decoding circuit XDEC and column decoding circuit YDEC. A control circuit and a data transmission circuit are provided between the memory banks, separating edge rows from adjacent memory banks, and the control circuit is configured to transmit control signals to the corresponding bank, and the data transmission circuit is configured to transmit data to the corresponding memory cell. The aforementioned organizational structure DRAM memory has a longer length in the column direction (Y-axis direction) than the row direction, and the corresponding control circuit and data transmission circuit have a longer length in column direction too, and so the distance from the control circuit and the data transmission circuit to each memory cell is also long, thus increasing the power consumption, raising the parasitic resistance and parasitic capacitance generated by the control circuit and the data transmission circuit, thereby reducing the data transmission rate and data transmission accuracy. In addition, the length in the column direction (Y-axis direction) is too long, which makes the aspect ratio insufficiently optimized, which affects packaging directly and may fail to meet packaging requirements.

Thus, the present disclosure provides a DRAM memory, including: a substrate; a plurality of memory banks arranged in rows and columns on the substrate, each memory bank is divided into three memory blocks in the column direction. Each memory block has a plurality of memory cells arranged in rows and columns. First, as the capacity of each memory bank is constant, by dividing each memory bank into three memory blocks in the column direction, the length of each memory block in the column direction will be shortened (comparing to dividing each memory bank into two memory blocks in the column direction), the length of the control circuit itself will be shortened, and the distance from the control circuit to the corresponding memory cell in the memory array in each memory block will be shortened, so that a large drive will not be required, power consumption is reduced. The length of the data transmission circuit itself is also shortened, and the distance from the data transmission circuit to the corresponding memory cell in the memory array in each memory block will be shortened too, so that the parasitic resistance and parasitic capacitance generated by the data transmission circuit are reduced. Therefore, the data transmission rate and data transmission accuracy are improved and power consumption reduce. In addition, the length of the memory block in the memory bank is shortened, which optimizes the layout of the memory banks in the DRAM memory, the aspect ratio of the DRAM memory is optimized, which is more beneficial to later packaging.

To better understand the above-mentioned goals, features and advantages of the present disclosure, the specific embodiments of the present disclosure will be described in detail below with reference to the accompanying drawings. When describing the embodiments of the present disclosure in detail, for illustration convenience, sections of the schematic diagram may be enlarged not proportionally to scale, and the schematic diagram is only an example, which should not limit the scope of the present disclosure herein. In addition, the three-dimensions of length, width and depth should be considered in actual production.

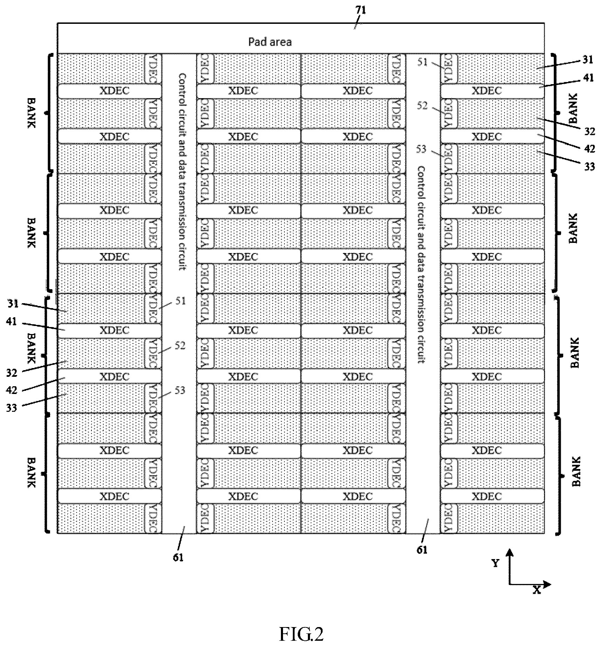

FIG. 2 is a schematic structural diagram of a DRAM memory according to the claimed invention.

Referring to FIG. 2, the DRAM memory includes: a substrate (not shown in the figure); a plurality of memory banks arranged in rows and columns on the substrate, each bank is divided into three memory blocks (31 or 32 or 33) in the column direction, and each memory block (31 or 32 or 33) has a plurality of memory cells arranged in rows and columns.

Generally a DRAM memory is divided into a plurality of memory banks. The number of memory banks in a DRAM memory can be 4, 8, 16 or other numbers. The memory capacity of each bank is the same, for example, if the DRAM memory capacity is 8Gb and there are 8 memory banks, the capacity of each bank is 1Gb. Each bank in the DRAM memory has its own bank address, which is configured to access the DRAM memory (such as reading, writing or refreshing). When accessing the memory, first look for the corresponding memory bank, and then find the corresponding memory cell in the memory bank. In this embodiment, referring to FIG. 2, a DRAM memory having 16 banks is illustrated as an example.

Each memory bank is divided into three memory blocks in the column direction. Each memory block has a memory array. The memory array includes a plurality of memory cells arranged in rows and columns. In this example, the three memory blocks include a first memory block 31, a second memory block 32, and a third memory block 33 arranged sequentially in the column direction. The first memory block 31, the second memory block 32, and the third memory block 33 are respectively connected with the corresponding row decoding circuit XDEC and the column decoding circuit YDEC (it should be noted that, in this example, the column direction refers to the Y axis direction, and the row direction refers to the X axis direction). First, as the capacity of each memory bank is constant, by dividing each memory bank into three memory blocks (the first memory block 31, the second memory block 32 and the third memory block 33) in the column direction, the length of each memory block in the column direction will be shortened (comparing to dividing each memory bank into two memory blocks in the column direction), the length of the control circuit itself will be shortened, and the distance from the control circuit to the corresponding memory cell in the memory array in each memory block will be shortened, so that a large drive will not be required, power consumption is reduced. The length of the data transmission circuit itself is also shortened, and the distance from the data transmission circuit to the corresponding memory cell in the memory array in each memory block will be shortened too, so that the parasitic resistance and parasitic capacitance generated by the data transmission circuit are reduced. Therefore, the data transmission rate and data transmission accuracy are improved and power consumption is reduced. In addition, the length of the memory block in the memory bank is shortened, which optimizes the layout of the memory banks in the DRAM memory, the aspect ratio of the DRAM memory is optimized, which is more beneficial to later packaging.

In the DRAM memory of the invention, the memory capacities of the first memory block 31, the second memory block 32, and the third memory block 33 are equal.

In the DRAM memory of the invention, the first memory block 31, the second memory block 32, and the third memory block 33 in each of the memory banks are respectively connected to the first column decoding circuit (YDEC) 51, the second column decoding circuit (YDEC) 52, and the third column decoding circuit (YDEC) 53. The first memory block 31, the second memory block 32, and the third memory block 33 in each of the memory banks are also connected to the first row decoding circuit (XDEC) 41 and the second row decoding circuit (XDEC) 42. The first column decoding circuit (YDEC) 51, the second column decoding circuit (YDEC) 52 and the third column decoding circuit (YDEC) 53 are respectively used for performing column addressing of the corresponding memory cells of the first memory block 31, the second memory block 32 and the third memory block 33. The first row decoding circuit (XDEC) 41 and the second row decoding circuit (XDEC) 42 are used to perform row addressing on the corresponding memory cells of the first memory block 31, the second memory block 32 and the third memory block 33. Therefore, it is possible to access (including reading, writing or refreshing) simultaneously the corresponding memory cells of the three memory blocks in a memory bank, which improves the operating efficiency of the DRAM memory.

In the DRAM memory of the invention, the first row decoding circuit 41 is connected to all the memory cells in the first memory block 31 and some memory cells in the second memory block 32 foris configured to performing row addressing on all the memory cells in the first memory block 31 and some memory cells in the second memory block 32. The second row decoding circuit 42 is connected to all the memory cells in the third memory block 33 and some memory cells in the second memory block 32 for performing row addressing on all memory cells in the third memory block 33 and some memory cells in the second memory block 32. Therefore, the row decodings are shared and controlled among the memory cells in the three memory blocks in one memory bank, thereby saving the chip area.

There is a circuit area 61 between the two adjacent columns of memory banks. The circuit area 61 has a control circuit and a data transmission circuit. The control circuit is configured to send control instructions and/or addresses to the corresponding memory banks. The control instructions include write instructions, read instructions, and refresh instructions. The addresses include the bank address of each bank and the row address and column address of the corresponding memory cell in the corresponding memory block in the bank. The data transmission circuit is configured to transmit data to or read data from the corresponding memory cell in the corresponding memory bank.

The substrate also has a pad area 71. The pad area 71 is generally located around the bank array. The pad area 71 has a plurality of first pad areas and a plurality of second pad areas. The plurality of first pad areas are connected with the control circuit, and the plurality of second pad areas are connected with the data transmission circuit.

In one embodiment, the process of addressing the DRAM memory is generally to first specify the address of the memory bank, then specify the row address, and then specify the column address.

It should be noted that other limitations or descriptions of the memory structure will not be repeated. For more details, please refer to the corresponding limitations or descriptions in the foregoing embodiment of the memory structure formation process.

Although the present disclosure has been disclosed as above in preferred embodiments, it is not intended to limit the present disclosure. Any person skilled in the art can use the methods and technical content disclosed above to make possible changes and modifications to the technical solutions of the present disclosure without departing from the scope of the present disclosure. The scope of the invention is defined by the appended claims.

## Claims

1. A DRAM memory, comprising a substrate and a plurality of memory banks; the plurality of memory banks are arranged in rows and columns on the substrate, wherein each of the plurality of memory banks is divided into three memory blocks (31, 32, 33) in a column direction, and each of the three memory blocks (31, 32, 33) comprises memory cells arranged in rows and columns; the three memory blocks comprise a first memory block (31), a second memory block (32), and a third memory block (33) that are sequentially arranged in the column direction;
wherein in each of the plurality of memory banks, the first memory block (31) is connected to a first column decoding circuit (51), the second memory block (32) is connected to a second column decoding circuit (52), and the third memory block (33) is connected to a third column decoding circuit (53);
wherein the first memory block (31) is connected to a first row decoding circuit (41); the second memory block (32) is connected to the first row decoding circuit (41); the second memory block (32) is connected to a second row decoding circuit (42); the third memory block (33) is connected to the second row decoding circuit (42);
wherein the first row decoding circuit (41) is connected to all memory cells in the first memory block (31) and some memory cells in the second memory block (32) for performing row addressing on all memory cells in the first memory block (31) and some memory cells in the second memory block (32), and the second row decoding circuit (42) is connected to all memory cells in the third memory block (33) and some memory cells in the second memory block (32) for performing row addressing on all memory cells in the third memory block (33) and some memory cells in the second memory block (32);
**characterized by** comprising:
a memory capacity of the first memory block (31), a memory capacity of the second memory block (32) and a memory capacity of the third memory block (33) are all equal.

2. The DRAM memory according to claim 1, further comprising a circuit area (61) between two adjacent columns of the plurality of memory banks, wherein the circuit area (61) comprises a control circuit and a data transmission circuit, the control circuit is configured to send control instructions and/or addresses to a corresponding one of the plurality of memory banks, and the data transmission circuit is configured to transmit data to or read data from a corresponding memory cell in the corresponding one of the plurality of memory banks.

3. The DRAM memory according to claim 2, further comprising a pad area (71), wherein the pad area (71) has a plurality of first pads and a plurality of second pads, wherein the plurality of first pads are connected to the control circuit, and the plurality of second pads are connected to the data transmission circuit.

## Patentansprüche

1. DRAM-Speicher, umfassend ein Substrat und eine Vielzahl von Speicherbänken; wobei die Vielzahl von Speicherbänken in Zeilen und Spalten auf dem Substrat angeordnet ist, wobei jede der Vielzahl von Speicherbänken in einer Spaltenrichtung in drei Speicherblöcke (31, 32, 33) unterteilt ist und jeder der drei Speicherblöcke (31, 32, 33) in Zeilen und Spalten angeordnete Speicherzellen umfasst; wobei die drei Speicherblöcke einen ersten Speicherblock (31), einen zweiten Speicherblock (32) und einen dritten Speicherblock (33) umfassen, die in der Spaltenrichtung sequentiell angeordnet sind;
wobei in jeder der Vielzahl von Speicherbänken der erste Speicherblock (31) mit einer ersten Spaltendecodierungsschaltung (51) verbunden ist, der zweite Speicherblock (32) mit einer zweiten Spaltendecodierungsschaltung (52) verbunden ist und der dritte Speicherblock (33) mit einer dritten Spaltendecodierungsschaltung (53) verbunden ist;
wobei der erste Speicherblock (31) mit einer ersten Zeilendecodierungsschaltung (41) verbunden ist; der zweite Speicherblock (32) mit der ersten Zeilendecodierungsschaltung (41) verbunden ist; der zweite Speicherblock (32) mit einer zweiten Zeilendecodierungsschaltung (42) verbunden ist; der dritte Speicherblock (33) mit der zweiten Zeilendecodierungsschaltung (42) verbunden ist;
wobei die erste Zeilendecodierungsschaltung (41) mit allen Speicherzellen in dem ersten Speicherblock (31) und einigen Speicherzellen in dem zweiten Speicherblock (32) verbunden ist, um eine Zeilenadressierung an allen Speicherzellen in dem ersten Speicherblock (31) und einigen Speicherzellen in dem zweiten Speicherblock (32) durchzuführen, und die zweite Zeilendecodierungsschaltung (42) mit allen Speicherzellen in dem dritten Speicherblock (33) und einigen Speicherzellen in dem zweiten Speicherblock (32) verbunden ist, um eine Zeilenadressierung an allen Speicherzellen in dem dritten Speicherblock (33) und einigen Speicherzellen in dem zweiten Speicherblock (32) durchzuführen;
**dadurch gekennzeichnet, dass** es Folgendes umfasst:
eine Speicherkapazität des ersten Speicherblocks (31), eine Speicherkapazität des zweiten Speicherblocks (32) und eine Speicherkapazität des dritten Speicherblocks (33), die alle gleich sind.

2. DRAM-Speicher nach Anspruch 1, der ferner einen Schaltungsbereich (61) zwischen zwei benachbarten Spalten der Vielzahl von Speicherbänken umfasst, wobei der Schaltungsbereich (61) eine Steuerschaltung und eine Datenübertragungsschaltung umfasst, wobei die Steuerschaltung so konfiguriert ist, dass sie Steueranweisungen und/oder Adressen an eine entsprechende Speicherbank der Vielzahl von Speicherbänken sendet, und die Datenübertragungsschaltung so konfiguriert ist, dass sie Daten an eine entsprechende Speicherzelle in der entsprechenden Speicherbank der Vielzahl von Speicherbänken sendet oder Daten aus dieser liest.

3. DRAM-Speicher nach Anspruch 2, der ferner einen Pad-Bereich (71) umfasst, wobei der Pad-Bereich (71) eine Vielzahl von ersten Pads und eine Vielzahl von zweiten Pads aufweist, wobei die Vielzahl von ersten Pads mit der Steuereinheit verbunden ist und die Vielzahl von zweiten Pads mit der Datenübertragungsschaltung verbunden ist.

## Revendications

1. Mémoire DRAM, comprenant un substrat et une pluralité de bancs de mémoire ; la pluralité de blocs de mémoire est disposée en lignes et en colonnes sur le substrat, chacun de la pluralité de blocs de mémoire étant divisé en trois blocs de mémoire (31, 32, 33) dans le sens des colonnes, et chacun des trois blocs de mémoire (31 , 32, 33) comprend des cellules mémoire disposées en lignes et en colonnes ; les trois blocs mémoire comprennent un premier bloc mémoire (31), un deuxième bloc mémoire (32) et un troisième bloc mémoire (33) qui sont agencés séquentiellement dans la direction des colonnes ;
dans lequel dans chacun de la pluralité de bancs de mémoire, le premier bloc mémoire (31) est connecté à un premier circuit de décodage de colonne (51), le deuxième bloc mémoire (32) est connecté à un deuxième circuit de décodage de colonne (52), et le troisième bloc mémoire (33) est connecté à un troisième circuit de décodage de colonne (53) ;
dans lequel le premier bloc mémoire (31) est connecté à un premier circuit de décodage de ligne (41) ; le deuxième bloc mémoire (32) est connecté au premier circuit de décodage de ligne (41) ; le deuxième bloc mémoire (32) est connecté à un deuxième circuit de décodage de ligne (42) ; le troisième bloc mémoire (33) est connecté au deuxième circuit de décodage de ligne (42) ;
dans lequel le premier circuit de décodage de ligne (41) est connecté à toutes les cellules mémoire du premier bloc mémoire (31) et à certaines cellules mémoire du deuxième bloc mémoire (32) pour effectuer un adressage de ligne sur toutes les cellules mémoire du premier bloc mémoire (31) et certaines cellules mémoire dans le deuxième bloc mémoire (32), et le deuxième circuit de décodage de ligne (42) est connecté à toutes les cellules mémoire dans le troisième bloc mémoire (33) et à certaines cellules mémoire dans le deuxième bloc mémoire (32) pour effectuer un adressage de ligne sur toutes les cellules mémoire du troisième bloc mémoire (33) et certaines cellules mémoire dans le deuxième bloc mémoire (32) ;
**caractérisé en ce qu'**il comprend :
une capacité de mémoire du premier bloc mémoire (31), une capacité de mémoire du deuxième bloc mémoire (32) et une capacité mémoire du troisième bloc mémoire (33) qui sont toutes égales.

2. Mémoire DRAM selon la revendication 1, comprenant en outre une zone de circuit (61) entre deux colonnes adjacentes de la pluralité de bancs de mémoire, dans laquelle la zone de circuit (61) comprend un circuit de commande et un circuit de transmission de données, le circuit de commande étant configuré pour envoyer des instructions de commande et/ou des adresses à un banc de mémoire correspondant parmi la pluralité de bancs de mémoire, et le circuit de transmission de données est configuré pour transmettre des données vers, ou lire des données à partir de, une cellule mémoire correspondante dans le banc de mémoire correspondant parmi la pluralité de bancs de mémoire.

3. Mémoire DRAM selon la revendication 2, comprenant en outre une zone de pastilles (71), dans laquelle la zone de pastilles (71) a une pluralité de premières pastilles et une pluralité de deuxièmes pastilles, dans laquelle la pluralité de premières pastilles sont connectées au circuit de commande, et la pluralité de deuxièmes pastilles sont connectés au circuit de transmission de données.
